# EUROPÄISCHE PATENTSCHRIFT

(11) **EP 1 387 945 B1**
(45) Veröffentlichungstag und Bekanntmachung des Hinweises auf die Patenterteilung: **13.07.2005**
(21) Anmeldenummer: 02712775.2
(22) Anmeldetag: 14.02.2002
(51) Int. Cl.: F02M 59/46, F02M 51/06, H01L 41/053

(54) **PIEZOELEKTRISCHES AKTORMODUL**
PIEZOELECTRIC ACTUATOR MODULE
MODULE ACTIONNEUR PIEZOELECTRIQUE

(30) Priorität: 14.04.2001 DE 10118563
(43) Veröffentlichungstag der Anmeldung: 11.02.2004
(73) Patentinhaber: ROBERT BOSCH GMBH, 70442 Stuttgart (DE)
(72) Erfinder: KIENZLER, Dieter, 71229 Leonberg (DE); SCHOLTEN, Werner, 70469 Stuttgart (DE); UHLMANN, Dietmar, 71404 Korb (DE); LOUTRAGE, Jean-Luc, 70469 Stuttgart (DE)
(86) Internationale Anmeldenummer: PCT/DE2002/000517
(87) Internationale Veröffentlichungsnummer: WO 2002/084107

(56) Entgegenhaltungen:
- WO-A-00/52322
- WO-A-00/71885
- DE-A- 10 016 247
- US-A- 5 031 841
- US-A- 5 239 223

## Beschreibung

### Stand der Technik

Die Erfindung geht von einem piezoelektrischen Aktormodul, insbesondere für einen Injektor im Hochdruckteil einer. Einspritzanlage mit dem Speichereinspritzsystem "Common Rail" eines Kraftfahrzeuges, gemäß der im Oberbegriff des Patentanspruches 1 näher definierten Art aus.

Ein derartiges Aktormodul ist aus der Praxis bekannt und kann insbesondere in Verbindung mit Common-Rail-Speichereinspritzsystemen für Dieselverbrennungsmaschinen eingesetzt werden. Dabei ist das piezoelektrische Aktormodul einem ventilartig ausgebildeten Ventilsteuermodul zugeordnet und dient zur Betätigung eines Ventilschließgliedes des Ventilsteuermoduls. Mittels des Ventilsteuermoduls ist wiederum eine Düsennadel eines Düsenmoduls des Einspritzventils betätigbar. Die Düsennadel wirkt mit mindestens einer zu einem Verbrennungsraum der Verbrennungsmaschine fuhrenden Einspritzöffnung zusammen.

Das piezoelektrische Aktormodul umfaßt üblicherweise einen Aktorfuß, der sich an einem Gehäuse des Einspritzventils abstützt, ein piezoelektrisches Bauelement, das beim Anlegen einer elektrischen Spannung eine Längung erfährt, sowie einen Aktorkopf, über den die Langung des piezoelektrischen Bauelements derart auf einen sogenannten Stellkolben ubertragen wird, daß dieser axial verschoben wird. Der Stellkolben wirkt über einen als Hydraulikkammer ausgebildeten hydraulischen Koppler mit einem sogenannten Betatigungskolben zusammen, der wiederum mit dem Ventilschließglied verbunden ist. Ein solcher Aufbau wird auch in der DE 199 46 831 beschrieben.

Aus der US-A-5 031 841 ist ein Einspritzventil mit einem Piezoaktor bekannt, der direkt in das Gehause des Einspritzventils eingesetzt ist. Eine radiale Abdichtung des Aktors zum Gehäuse hin findet nicht statt.

Aus der WO 00/52322 A ist ein Kraftstoffinjektor mit Piezoaktor bekannt, der ebenfalls in einem Gehause untergebracht ist, wobei zwischen Aktor und Gehäuse eine nicht dichtende Feder angeordnet ist.

Aus der WO 00/71885 A ist ein Kraftstoffeinspritzventil bekannt, das einen Piezoaktor aufweist, dessen Aktorkopf uber eine Membran mit einem Aktorgehäuse verbunden ist. Eine zwischen Aktor und Aktorgehause angeordnete dichtende Hülse ist nicht vorgesehen.

Eine Aktorvorrichtung mit einem piezoelektrischen Aktormodul nach dem Oberbegriff des Anspruchs 1 ist aus der Druckschrift US 5 239 223 A bekannt.

### Vorteile der Erfindung

Das piezoelektrische Aktormodul nach der Erfindung mit den Merkmalen nach dem Oberbegriff des Patentanspruches 1, bei welchem sich an den Aktorfuß eine Membran anschließt, die sich im wesentlichen in radialer Richtung erstreckt und mit der Hülse verbunden ist, hat demgegenüber den Vorteil, daß die Membran äußerst niedrig baut und daher nur einen geringen Bauraum benötigt. Zudem sind die Kosten der Membran deutlich geringer als diejenigen eines Faltenbalgs.

Die Membran des piezoelektrischen Aktormoduls nach der Erfindung ist vorzugsweise derart ausgelegt, daß sie einer Verschiebung des Aktorkopfes von beispielsweise 40 µm, die durch eine Längung des piezoelektrischen Bauelements ausgelöst wird, folgen kann. Wenn die Membran das Aktormodul in axialer Richtung dichtet, so bildet sie zusammen mit der das Aktormodul radial begrenzenden Hülse eine schützende Ummantelung des Aktormoduls. Die Gesamtheit der Bauteile aus dem Aktorfuß, dem piezoelektrischem Bauelement, dem Aktorkopf, der Hülse und der Membran bildet somit eine Art piezoelektrische Aktorpatrone.

Die Membran hat somit folgende Funktionen, nämlich eine Dichtfunktion; eine Temperaturausgleichsfunktion zwischen dem piezoelektrischen Bauelement mit negativer Lägenausdehnung und der Hülse mit positiver Längenausdehnung bei Erwärmung; sowie die Funktion der Übertragung des Aktorhubs (Verbindung Aktorkopf und Hülse).

Die Membran kann in einer vorteilhaften Ausführung beispielsweise aus einem Federstahl oder einem ausscheidungshärtenden Werkstoff gefertigt sein.

Eine besonders sichere Verbindung der Membran mit dem Aktorfuß kann erreicht werden, wenn diese beiden Bauteile miteinander verschweißt sind.

Des weiteren kann die Membran mit der Hülse verschweißt oder einstückig mit der Hülse gefertigt sein. In beiden Fällen weist die Membran vorteilhaft einen zentralen Durchbruch für einen verjüngten Bereich des Aktorfußes zur Übertragung der Längung des piezoelektrischen Bauelements auf den mindestens einen Kolben auf. Die Membran ist dann ringförmig ausgebildet.

Nach einer bevorzugten Ausführungsform des piezoelektrischen Aktormoduls nach der Erfindung weist die Membran, die ringförmig ausgebildet ist, einen gebogten Querschnitt auf. Bei dieser Ausführungsform sind die im Betrieb auf die Membran einwirkenden mechanischen Belastungen am geringsten.

Die Membran kann aber bei einer Ausführungsvariante auch eine im wesentlichen ebene Formgebung aufweisen.

Die Dicke der Membran beträgt bei einer vorteilhaften Ausführung beispielsweise etwa 0,2 mm.

Weitere Vorteile und vorteilhafte Weiterbildungen des Gegenstandes nach der Erfindung ergeben sich aus der Beschreibung, der Zeichnung und den Patentansprüchen.

### Zeichnung

Drei Ausführungsbeispiele des piezoelektrischen Aktormoduls nach der Erfindung sind in der Zeichnung schematisch vereinfacht dargestellt und werden in der nachfolgenden Beschreibung näher erläutert. Es zeigen
Figur 1 ein piezoelektrisches Aktormodul nach der Erfindung, welches als Ansteuereinheit eines Einspritzventils dient, in einem vereinfachten Längsschnitt;
Figur 2 eine perspektivische Darstellung eines Ausschnitts eines Aktorfußbereichs des Aktormoduls nach Figur 1;
Figur 3 eine zweite Ausführungsform eines piezoelektrischen Aktormoduls nach der Erfindung bei einem Einspritzventil in einer Figur 1 entsprechenden Darstellung; und
Figur 4 eine dritte Ausführungsform eines erfindungsgemäßen piezoelektrischen Aktormoduls im Längsschnitt.

### Beschreibung der Ausführungsbeispiele

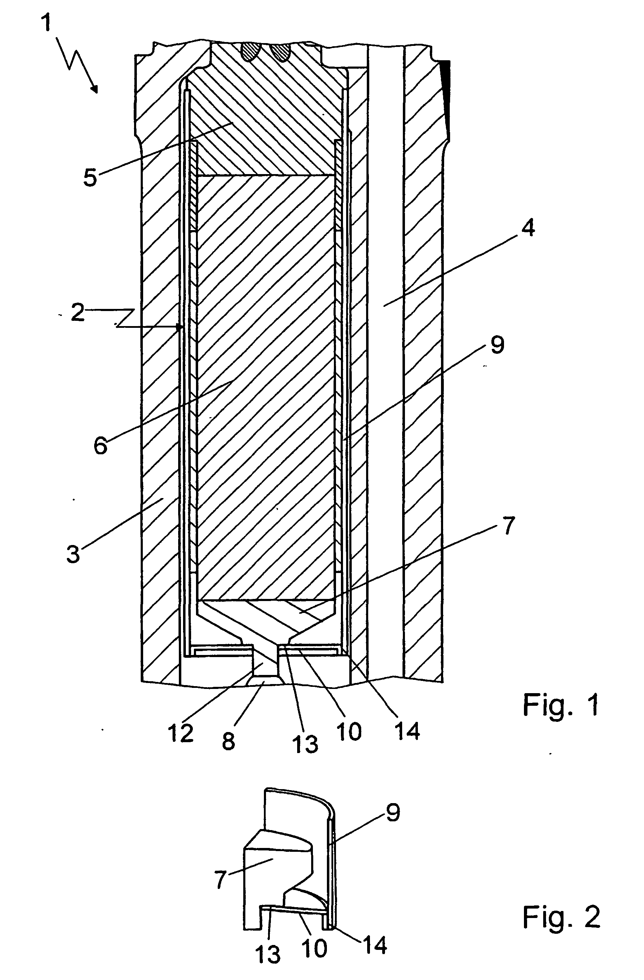

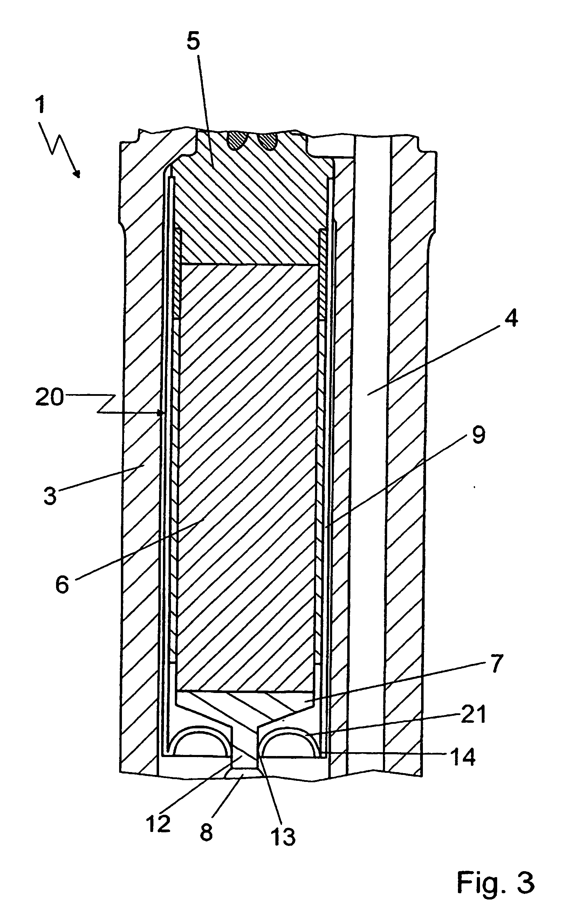

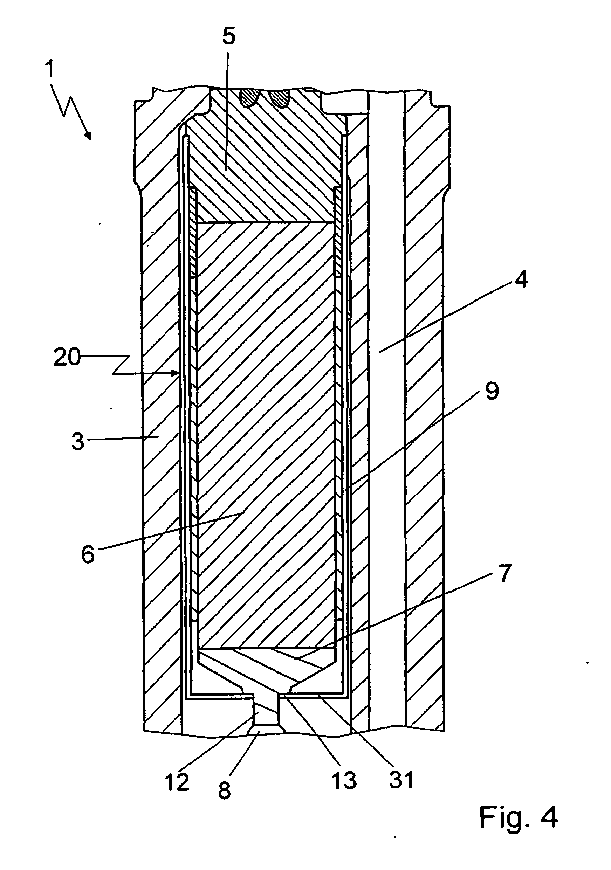

Das in den Figuren 1 und 2 dargestellte Ausführungsbeispiel zeigt einen Teilbereich eines Kraftstoffeinspritzsystems 1, welches zum Einbau in eine Brennkraftmaschine eines Kraftfahrzeugs vorgesehen ist und hier als Common-Rail-Injektor zur Einspritzung von vorzugsweise Dieselkraftstoff ausgebildet ist.

Der Injektor umfaßt ein Aktormodul 2, das in einem Haltekörper 3 untergebracht ist und über ein Kopplermodul einem ventilartig ausgebildeten Ventilsteuermodul zugeordnet ist, das zur Betätigung einer Düsennadel dient, die in einem hier nicht näher dargestellten Düsenmodul angeordnet ist. In dem Haltekörper 3 ist des weiteren ein parallel zu dem Aktormodul 2 verlaufender Kraftstoffzufuhrkanal 4 (Hochdruckbohrung) ausgebildet, der zum Transport von Kraftstoff von einer Common-Rail-Speichereinheit zu dem Düsenmodul des Einspritzventils 1 dient.

Das Aktormodul 2 umfaßt einen sogenannten Aktorfuß 5, über den sich das Aktormodul 2 an dem Haltekörper 3 abstützt, ein sich an den Aktorfuß 5 in axialer Richtung anschließendes piezoelektrisches Bauelement 6, welches wie üblich aus einer Vielzahl von Schichten aus einem piezoelektrischen Werkstoff gefertigt ist, sowie einen sich an das piezoelektrische Bauelement 6 in der dem Aktorfuß 5 abgewandten Richtung anschließenden sogenannten Aktorkopf 7. Der Aktorkopf 7 dient zur Übertragung einer Längung bzw. Kontraktion des piezoelektrischen Bauelements 6 auf einen an sich bekannten, hier nicht dargestellten Stellkolben der Ventilsteuereinheit, welche im Prinzip vorzugsweise wie ein in der DE 199 46 831 beschriebenes Ventil zum Steuern von Flüssigkeiten aufgebaut ist.

So kann der Stellkolben in üblicher Weise über einen als Hydraulikkammer ausgebildeten, hydraulischen Koppler (Kopplermodul) mit einem sogenannten Betätigungskolben in Wirkverbindung stehen, wobei der untere Betätigungskolben vorzugsweise wiederum mit einem Ventilschließglied verbunden ist, das mit einem Ventilsitz zusammenwirkt.

Die Übertragung der Längung des piezoelektrischen Bauelements 6 erfolgt über eine hier als Ausgleichselement dienende Kugel 8. Die Kugel 8 hat beispielsweise einen Durchmesser von etwa 3 mm.

Das piezoelektrische Aktormodul 2 ist hier von einer sich in axialer Richtung erstreckenden, im wesentlichen zylinderförmig ausgebildeten, dünnwandigen Hülse 9 umgeben, die beispielsweise aus kostengünstigem rostfreiem Stahl gefertigt ist und das Aktormodul 2 radial dichtet.

An der dem Aktorfuß 5 abgewandten Seite ist das piezoelektrische Aktormodul 2 in axialer Richtung mittels einer vorliegend aus Federstahl gebildeten Membran 10 abgedichtet, welche sich im wesentlichen in radialer Richtung erstreckt, ringförmig ausgebildet ist und einen zentralen Durchbruch für einen zapfenförmigen Bereich 12 des Aktorkopfes 7 aufweist.

Die Membran hat beispielsweise eine Dicke von 0,08 mm bis 0,2 mm, einen Außendurchmesser von 9,5 mm und einen Innendurchmesser von 2,5 mm.

Die Membran 10, deren Formgebung hier im wesentlichen eben bzw. plattenartig ist, ist an der dem zapfenförmigen Bereich 12 zugewandten, inneren Begrenzung über eine Schweißnaht 13 mit dem Aktorkopf 7 fest verbunden. An der äußeren Begrenzung, die der Hülse 9 zugewandt ist, ist die Membran 10 über eine Schweißnaht 14 mit der Hülse 9 verbunden.

In Figur 3 ist eine alternative Ausführungsform eines piezoelektrischen Aktormoduls 20 dargestellt. Diese Ausführungsform unterscheidet sich von derjenigen nach den Figuren 1 und 2 durch eine Membran 21, welche elliptisch bis kreisbogenförmig gewölbt ist, wobei sich die Wölbung in Richtung des piezoelektrischen Bauelements 6 erstreckt . Die Membran 21, die sich im wesentlichen in radialer Richtung erstreckt, ist ebenfalls ringförmig ausgebildet und an der inneren Begrenzung über eine Schweißnaht 13 mit dem Aktorkopf 7 und an der äußeren Begrenzung über eine Schweißnaht 14 mit der Hülse 9 verbunden. Bei dieser Ausführungsform sind die mechanischen Belastungen, die im Betrieb auf die Membran einwirken, am geringsten.

In Figur 4 ist eine dritte Ausführungsform eines piezoelektrischen Aktormoduls 30 nach der Erfindung dargestellt. Diese Ausführungsform unterscheidet sich von derjenigen nach den Figuren 1 und 2 dadurch, daß sie eine Membran 31 aufweist, welche einstückig mit der Hülse 9 gefertigt ist und mithin mit der Hülse 9 eine Einheit bildet. Die Membran 31, die eine flache bzw. ebene Geometrie aufweist, ist ringförmig ausgebildet und an ihrer inneren Begrenzung über eine Schweißnaht 13 mit dem Aktorkopf 7 verbunden.

Es versteht sich, daß die Erfindung nicht auf die dargestellten Ausführungsformen beschränkt ist. Vielmehr kann die Membran auch alle anderen denkbaren Formen aufweisen, die der Fachmann für den gegebenen Anwendungsfall für geeignet erachtet.

Wenngleich der beschriebene Einsatz des erfindungsgemäßen piezoelektrischen Aktormoduls bei einem Kraftstoff-Einspritzventil sehr vorteilhaft ist, so ist die Verwendung eines nach der Erfindung ausgestalteten piezoelektrischen Aktormoduls auch in anderen Anwendungsbereichen, insbesondere in Bereichen, in denen ein piezoelektrisches Bauelement vor Schmutz oder einem aggressiven Medium zu schützen ist, denkbar.

## Patentansprüche

1. Aktorvorrichtung, umfassend ein piezoelektrisches Aktormodul (2; 20; 30) mit einem zwischen einem Aktorfuß (5) und einem Aktorkopf (7) vorgesehenen piezoelektrischen Bauelement (6), einen Haltekörper (3) mit einer Längsöffnung, in der das Aktormodul (2; 20; 30) unter Ausbildung eines Ringspalts untergebracht ist, sowie eine sich im wesentlichen in radialer Richtung erstreckende Membran (10; 21; 31), die einerseits an dem Aktorkopf (7), welcher mit einem vom piezoelektrischen Bauelement (6) zu betätigenden Bauteil zusammenwirkt, befestigt und andererseits an ihrer dem Haltekörper (3) zugewandten Begrenzung ortsfest gehalten ist,
**dadurch gekennzeichnet,**
**dass** das piezoelektrische Bauelement (6) durch eine sich im Ringspalt in axialer Richtung erstreckende Hülse (9) geführt ist, die einenends am Aktorfuß (5) abgestützt und anderenends mit der Membran (10; 21; 31) verbunden ist.

2. Aktorvorrichtung nach Anspruch 1, **dadurch gekennzeichnet, dass** die Membran (10; 21; 31) mit dem Aktorkopf (7) verschweißt ist.

3. Aktorvorrichtung nach Anspruch 1 oder 2, **dadurch gekennzeichnet, dass** die Membran (10; 21) mit der Hülse (9) verschweißt ist.

4. Aktorvorrichtung nach Anspruch 1 oder 2, **dadurch gekennzeichnet, dass** die Membran (31) einstückig mit der Hülse (9) gefertigt ist.

5. Aktorvorrichtung nach einem der Ansprüche 1 bis 4, **dadurch gekennzeichnet, dass** die Membran (21) einen gebogten Querschnitt aufweist.

6. Aktorvorrichtung nach einem der Ansprüche 1 bis 4, **dadurch gekennzeichnet, dass** die Membran (10; 31) eine im wesentlichen ebene Geometrie aufweist.

7. Aktorvorrichtung nach einem der Ansprüche 1 bis 6, **dadurch gekennzeichnet, dass** die Membran (10; 21; 31) eine Dicke von etwa 0,2 mm aufweist.

8. Verwendung einer Aktorvorrichtung nach einem der Ansprüche 1 bis 7 als Ansteuereinheit eines Kraftstoff-Einspritzventils (1), insbesondere eines Common-Rail-Einspritzventils, eines Kraftfahrzeugs.

## Claims

1. Actuator device comprising a piezoelectric actuator module (2; 20; 30) having a piezoelectric element (6) which is provided between an actuator base (5) and an actuator head (7), a securing element (3) with a longitudinal opening in which the actuator module (2; 20; 30) is accommodated with the formation of an annular gap, and a diaphragm (10; 21; 31) which extends essentially in the radial direction and is attached at one end to the actuator head (7) which interacts with a component to be activated by the piezoelectric element (6), and at the other end is held fixedly at its delimiting element facing the securing element (3), **characterized in that** the piezoelectric element (6) is guided through a sleeve (9) which extends in the axial direction in the annular gap and is supported at one end on the actuator base (5) and is connected at the other end to the diaphragm (10; 21; 31).

2. Actuator device according to Claim 1, **characterized in that** the diaphragm (10; 21; 31) is welded to the actuator head (7).

3. Actuator device according to Claim 1 or 2, **characterized in that** the diaphragm (10; 21) is welded to the sleeve (9).

4. Actuator device according to Claim 1 or 2, **characterized in that** the diaphragm (31) is fabricated in one piece with the sleeve (9).

5. Actuator device according to one of Claims 1 to 4, **characterized in that** the diaphragm (21) has a bent cross section.

6. Actuator device according to one of Claims 1 to 4, **characterized in that** the diaphragm (10; 31) has an essentially planar geometry.

7. Actuator device according to one of Claims 1 to 6, **characterized in that** the diaphragm (10; 21; 31) has a thickness of approximately 0.2 mm.

8. Use of an actuator device according to one of Claims 1 to 7 as a drive unit of a fuel injection valve (1), in particular of a common-rail injection valve, of a motor vehicle.

## Revendications

1. Dispositif actionneur composé d'un module d'actionneur (2 ; 20 ; 30) piézoélectrique comportant un élément (6) piézoélectrique prévu entre un pied d'actionneur (5) et une tête d'actionneur (7), un corps de maintien (3) muni d'une ouverture longitudinale dans laquelle le module d'actionneur (2 ; 20 ; 30) est introduit en formant un intervalle annulaire et une membrane (10 ; 21 ; 31) qui s'étend principalement en direction radiale et qui d'une part est fixée à la tête d'actionneur (7) qui interagit avec un composant à manoeuvrer par l'élément (6) piézoélectrique, et d'autre part est maintenue à demeure sur sa limite orientée vers le corps de maintien (3),
**caractérisé en ce que**
l'élément (6) piézoélectrique est guidé par un manchon (9) qui s'étend en direction axiale dans l'intervalle annulaire et dont une extrémité s'appuie sur le pied d'actionneur (5) alors que l'autre extrémité est reliée à la membrane (10 ; 21 ; 31).

2. Dispositif actionneur selon la revendication 1,
**caractérisé en ce que**
la membrane (10 ; 21 ; 31) est soudée à la tête d'actionneur (7).

3. Dispositif actionneur selon la revendication 1 ou 2,
**caractérisé en ce que**
la membrane (10 ; 21) est soudée au manchon (9).

4. Dispositif actionneur selon la revendication 1 ou 2,
**caractérisé en ce que**
la membrane (31) est fabriquée en une seule pièce avec le manchon (9).

5. Dispositif actionneur selon l'une des revendications 1 à 4,
**caractérisé en ce que**
la membrane (21) présente une section transversale courbe.

6. Dispositif actionneur selon l'une des revendications 1 à 4,
**caractérisé en ce que**
la membrane (10 ; 31) présente une géométrie pratiquement plane.

7. Dispositif actionneur selon l'une des revendications 1 à 6,
**caractérisé en ce que**
la membrane (10 ; 21 ; 31) a une épaisseur d'environ 0,2 mm.

8. Utilisation d'un dispositif actionneur selon l'une des revendications 1 à 7, comme unité de commande d'un injecteur de carburant (1), en particulier un injecteur de rampe commune dans un véhicule automobile.
